# EUROPEAN PATENT SPECIFICATION

(11) **EP 1 691 362 B1**
(45) Date of publication and mention of the grant of the patent: **21.04.2010**
(21) Application number: 04799948.7
(22) Date of filing: 30.11.2004
(51) Int. Cl.: G11B 7/26, G03F 7/004

(54) **PROCESS FOR PRODUCING ORIGINAL DISC FOR OPTICAL DISC AND ORIGINAL DISC FOR OPTICAL DISC**
PROZESS ZUR HERSTELLUNG EINES ORIGINALDATENTRÄGERS FÜR EINEN OPTISCHEN DATENTRÄGER UND ORIGINALDATENTRÄGER FÜR EINEN OPTISCHEN DATENTRÄGER
PROCEDE DE PRODUCTION DE DISQUE ORIGINAL DE DISQUE OPTIQUE ET DISQUE ORIGINAL DE DISQUE OPTIQUE

(30) Priority: 01.12.2003 JP 2003401836
(43) Date of publication of application: 16.08.2006
(73) Proprietor: Sony Corporation, Tokyo 141-0001 (JP)
(72) Inventor: SHIRASAGI, Toshihiko C/O SONY DISC&DIG. SOL. INC., Shinagawa-ku, Tokyo 1410001 (JP); MINEGISHI, Shinji C/O SONY DISC & DIG. SOL.INC., Shinagawa-ku, Tokyo 1410001 (JP)
(74) Representative: Müller, Frithjof E.
(86) International application number: PCT/JP2004/018098
(87) International publication number: WO 2005/055224

(56) References cited:
- JP-A- 2 029 955
- JP-A- 2 029 955
- JP-A- 2 238 457
- JP-A- 8 180 468
- JP-A- 8 227 538
- JP-A- 11 203 731
- JP-A- 60 095 741
- JP-A- 2003 237 242
- JP-A- 2003 315 988
- JP-A- 2003 315 988
- NOBUYOSHI KOSHIDA ET AL: "50-NM METAL LINE FABRICATION BY FOCUSED ION BEAM AND OXIDE RESISTS" 1 November 1991 (1991-11-01), JAPANESE JOURNAL OF APPLIED PHYSICS, JAPAN SOCIETY OF APPLIED PHYSICS, TOKYO.; JP, PAGE(S) 3246 - 3249 , XP000263412 ISSN: 0021-4922 * the whole document *

## Description

### Technical Field

The invention relates to a manufacturing method of a master disc for an optical disc which is manufactured by using an inorganic resist film and relates to the master disc for the optical disc.

JP 2003-315988 discloses a resist material and method for materializing microfabrication by patterning a resist layer to prescribed shapes. The resist layer includes a incomplete oxide of transition metal referring to a compound having a oxygen content in the incomplete oxide of the transition metal lower than the oxygen content of a stoichiometric composition meeting the valence that the transition metal can take.

### Background Art

In recent years, in association with the realization of a high capacity of an optical disc, pattern precision below about tens of nm is necessary for a microfabrication of an optical device or the like. To realize such high precision, development is being progressed in various fields such as light source, resist material, stepper, and the like.

A method of shortening a wavelength of an exposing light source, a method of using an electron beam or ion beam which has finely been converged, and the like are effective as methods of improving microfabrication dimensional precision. However, since an apparatus having the exposing light source of a short wavelength or irradiating sources of the electron beam and the ion beam is extremely expensive, such methods are improper for supplying a reasonable device.

Therefore, a method of devising an irradiating method, a method of using a special mask called a phase shift mask, and the like have been proposed as methods of improving the microfabrication dimensional precision while using the same light source as that of the existing exposing apparatus. As further another method, a method of forming a resist by a multilayer, a method of using an inorganic resist, and the like have been tried.

At present, for example, an exposing method in which the organic resist such as novolak system resist, chemical sensitizing resist, or the like and ultraviolet rays serving as an exposing light source are combined is generally used. Although the organic resist has generality and is widely used in the field of photolithography, since its molecular weight is large, a pattern of a boundary portion between an exposing portion and a non-exposing portion becomes obscure and there is a limitation in the microfabrication precision.

On the other hand, in the inorganic resist, since its molecular weight is small, a clear pattern is obtained in the boundary portion between the exposing portion and the non-exposing portion and the fabrication of higher precision than that of the organic resist can be realized. For example, there is an example of the microfabrication in which MoO₃, WO₃, or the like is used as a resist material and the ion beam is used as an exposing light source (refer to the document of Nobuyoshi Koshida, Kazuyoshi Yoshida, Shinichi Watanuki, Masanori Komuro, and Nobufumi Atoda, "50-nm Metal Line Fabrication by Focused Ion Beam and Oxide Resists", Jpn. J. Appl. Phys., Vol. 30 (1991), pp3246). There is also a fabrication example in which SiO₂ is used as a resist material and the electron beam is used as an exposing light source (refer to the document of Sucheta M. Gorwadkar, Toshimi Wada, Satoshi Hiraichi, Hiroshi Hiroshima, Kenichi Ishii, and Masanori Komuro, "SiO2/c-Si Bilayer Electron-Beam Resist Process for Nano-Fabrication", Jpn. J. Appl. Phys . , Vol. 35 (1996), pp6673). Further, a method in which chalcogenide glass is used as a resist material and lasers having wavelengths of 476 nm and 532 nm and ultraviolet rays from a mercury xenon lamp are used as exposing light sources has also been examined (for example, refer to the document of S.A. Kostyukevych, "Investigations and modeling of physical processes in an inorganic resist for use in UV and laser lithography", SPIE Vol. 3424 (1998), pp20).

However, in the case of using the electron beam or the ion beam as an exposing light source, although many kinds of inorganic resist materials can be combined as mentioned above and the concave and convex patterns can be also microfabricated by finely converging the electron beam or the ion beam, the apparatus having the irradiating sources of the electron beam and the ion beam is expensive as mentioned above and has a complicated structure, so that it is improper for supplying the reasonable optical disc.

In terms of such reasons, it is desirable that the light from a laser apparatus or the like built in the existing exposing apparatus, that is, ultraviolet rays or visible light can be used. However, as a material which can be cut by the ultraviolet rays or the like among the inorganic resist materials, only the chalcogenide material as mentioned above has been reported. This is because in the inorganic resist materials other than the chalcogenide material, the light such as ultraviolet rays or the like is transmitted, an amount of absorption of a light energy is remarkably small, and it is not practical.

Although a combination of the existing exposing apparatus and the chalcogenide material mentioned above is a practical combination in view of economy, there is such a problem that the chalcogenide material contains a material such as Ag₂S₃, Ag-As₂S₃ , Ag₂Se-GeSe, or the like which is harmful to the human body. Therefore, it is difficult to use such a material from a viewpoint of industrial production.

Therefore, there have been proposed methods of realizing the microfabrication of the master disc for the optical disc on the basis of a principle that in the case of an incomplete oxide of a transition metal as an oxide whose oxygen content is slightly deviated from a stoichiometric composition of a transition metal oxide instead of a complete oxide of a transition metal such as MoO₃, WO₃, or the like, an absorption amount of the ultraviolet rays or the visible light is large and a chemical property is changed by the absorption.

A method whereby an incomplete oxide of, for example, W and Mo is used as a resist material, and a phase change is caused by the heat of the exposing apparatus of the laser or the like, thereby eventually realizing the microfabrication at low costs is also incorporated in the above proposed methods. The incomplete oxide of the transition metal mentioned here denotes a compound whose oxygen content is deviated in the direction in which it is smaller than that of the stoichiometric composition according to a valence number which the transition metal can have, that is, a compound in which the oxygen content in the incomplete oxide of the transition metal is smaller than the oxygen content of the stoichiometric composition according to the valence number which the transition metal can have.

However, in the case where the inorganic resist is phase-changed by the heat of the laser or the like and the fine concave/convex patterns such as pits, grooves, and the like are formed as mentioned above, the larger a distance from the surface of the inorganic resist is, the smaller the conductivity of the heat is, so that a change ratio of a phase change reaction, that is, a change from amorphous to crystal decreases. Therefore, there is a risk that, in a portion where the change ratio is small, a development shortage phenomenon occurs, the bottom surfaces of the pits, grooves, and the like are formed in the incomplete state, and further, angles of inclination or the like of the wall surfaces of the pits and grooves become gentle.

In the method of using the phase change, since the shapes and the inclination angles of the fine concave/convex patterns such as pits, grooves, and the like are unconditionally determined in accordance with sensitivity of the inorganic resist master disc, an exposing power of the exposing apparatus, developing conditions , and the like, it is difficult to finely adjust them.

Further, since a depth of fine concave/convex patterns such as pits, grooves, and the like, in other words, a height of stamper is unconditionally determined by a thickness of inorganic resist film, it is difficult that the fine concave/convex patterns of different depths are formed in the same plane of the optical disc. For example, since the optimum depths are different with respect to the fine concave/convex patterns of the pits for a ROM (Read Only Memory) and the grooves for the additional recording, a master disc for a hybrid type optical disc having both of the pits and grooves cannot be manufactured. Although the depths of the concave/convex patterns can be also controlled by adjusting the exposing power, according to such a method, it is difficult to stably form the concave/convex patterns of a predetermined depth.

It is, therefore, an object of the invention to provide a manufacturing method of a master disc for an optical disc whereby, when an inorganic resist made of an incomplete oxide of a transition metal is phase-changed by the heat and fine concave/convex patterns such as pits, grooves, and the like are formed, sensitivity of an inorganic resist film is changed so that the wall surfaces of the pits and grooves are stably formed in a flat shape and, further, angles of inclination of the bottom surfaces of the pits and grooves are properly formed and to provide the master disc for the optical disc manufactured by such a method.

It is another object of the invention to provide a manufacturing method of a master disc for an optical disc whereby shapes and angles of inclination of fine concave/convex portions such as pits, grooves, and the like are finely adjusted by changing sensitivity of an inorganic resist film and to provide the master disc for the optical disc manufactured by such a method.

It is further another object of the invention to provide a manufacturing method of a master disc for an optical disc whereby sensitivity of an inorganic resist film is changed so that fine concave/convex patterns such as pits, grooves, and the like of different depths can be formed in a same plane and to provide the master disc for the optical disc manufactured by such a method.

### Disclosure of Invention

According to the invention, there is provided a manufacturing method of a master disc for an optical disc, comprising:
a film forming step of forming an inorganic resist layer made of an incomplete oxide of a transition metal as a film onto a substrate; and
a step of forming resist patterns including concave/convex shapes by exposing and developing the inorganic resist layer,
wherein in the film forming step, oxygen concentration of the inorganic resist layer is made different in its thickness direction.
In the film forming step, a single element or alloy of the transition metal, or an oxide of them is used as a target material, the inorganic resist layer is formed as a film onto the substrate by a sputtering method using oxygen or nitrogen as a reactive gas, and
the oxygen concentration of the inorganic resist layer is made different in the thickness direction by changing at least either a film forming electric power or a reactive gas ratio.
According to the invention, there is provided a master disc for an optical disc which is used when the optical disc having concave/convex shapes is manufactured, wherein
a substrate is coated with an inorganic resist layer in which oxygen concentration is made different in its thickness direction and which is made of an incomplete oxide of a transition metal, and the concave/convex shapes are formed in the inorganic resist layer.

### Brief Description of Drawings

Fig. 1 is a schematic diagram showing each step of a manufacturing method of a master disc for an optical disc and a stamper for molding according to the invention.
Fig. 2 is a schematic diagram for use in explanation of concave/convex shapes formed by the first embodiment of the manufacturing method of the master disc for the optical disc according to the invention.
Fig. 3 is a schematic diagram for use in explanation of concave/convex shapes formed by the second embodiment of the manufacturing method of the master disc for the optical disc according to the invention.
Fig. 4 is a schematic diagram for use in explanation of the case where the concave/convex shapes of different depths are formed by the second embodiment.
Fig. 5 is a block diagram showing a structure of a film forming apparatus which can embody the manufacturing method of the master disc for the optical disc according to the invention.

### Best Mode for Carrying Out the Invention

According to the invention, a laser beam is irradiated onto an inorganic resist layer made of an incomplete oxide of a transition metal and concave/convex shapes are formed by using a principle that when an amount of heat generated by exposure exceeds a threshold value. the incomplete oxide changes from an amorphous state to a crystal state and becomes soluble to alkali.

Therefore, the threshold value corresponds to sensitivity. If the threshold value is small, the sensitivity is high. The sensitivity of the inorganic resist changes in accordance with an oxygen concentration (which denotes an oxygen content) in the inorganic resist layer. The higher the oxygen concentration is, the higher the sensitivity is. The oxygen concentration changes in accordance with a film forming electric power or a reactive gas ratio during the film forming process by a sputtering method or the like of the inorganic resist layer. Therefore, in the invention, by using such a principle, it is intended to solve the foregoing problems by sequentially changing the sensitivity of the inorganic resist in one resist layer.

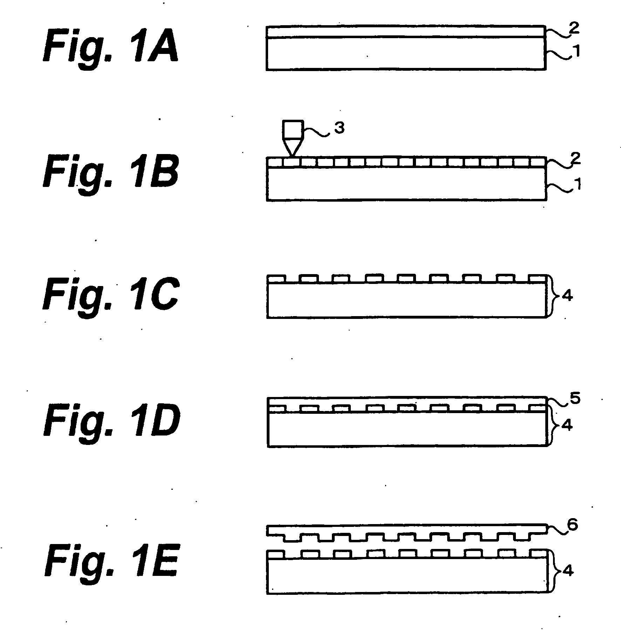

A manufacturing method of a master disc for an optical disc according to the first embodiment of the invention will now be described with reference to Fig. 1. First, as shown in Fig. 1A, a resist layer 2 made of an inorganic resist material made of an incomplete oxide of a transition metal is formed as a film onto a substrate 1 made of glass or an Si wafer. As a film forming method in this instance, for example, a sputtering method can be mentioned. In the invention, for example, a film forming apparatus which can embody the film forming process by the sputtering method is used.

Subsequently, as shown in Fig. 1B , the resist layer 2 is exposed by using an exposing apparatus 3 for irradiating a laser or the like to the inorganic resist layer. In this case, the substrate 1 on which the inorganic resist layer has been formed is rotated. With respect to pits for a ROM, such an exposure is a selective exposure corresponding to the concave/convex shapes serving as signal patterns to be recorded. With respect to grooves for the additional recording, it is a continuous exposure to form the grooves. For example, a blue laser diode which generates a laser beam of a wavelength of 405 nm is used for a laser in this case.

After that, the exposed substrate is developed by an alkali liquid by using a developing apparatus. A dipping method by dipping, a method of coating chemicals onto the substrate which is rotated by a spinner, or the like is used as a developing method. As a developer, an organic alkali developer such as NMD-3 (registered trademark: made by Tokyo Ohka Kogyo Co., Ltd.) or the like, an inorganic alkali developer such as KOH, NaOH, or phosphoric acid system or the like is used. After the development, a master disc 4 (for the optical disc) on which the concave/convex shapes have been formed as shown in Fig. 1C is obtained.

Subsequently, as shown in Fig. 1D , a metal nickel film 5 is precipitated onto the concave/convex pattern surface of the master disc 4 for the optical disc by an electroforming method. After the film 5 is peeled off from the master disc 4 for the optical disc, a predetermined process is performed and a stamper 6 for molding onto which the concave/convex patterns of the master disc 4 for the optical disc have been transferred is obtained as shown in Fig. 1E.

In the case of forming the inorganic resist layer 2 shown in Fig. 1A as a film onto the substrate 1, although a film thickness of inorganic resist layer 2 can be arbitrarily set, it is necessary to set the thickness so as to obtain a desired depth of pit or groove. In the case of the optical disc of the Blu-ray Disc (hereinafter, properly abbreviated to a BD) standard, it is desirable to set the thickness in a range of 10 to 80 nm. In the case of the DVD (Digital Versatile Disc), it is desirable to set the thickness in a range of 100 to 190 nm. As a target material upon sputtering, a single element of a transition metal such as tungsten (W), molybdenum (Mo), tungsten molybdenum (WMo), or the like, its alloy, or an oxide of them is used. Oxygen or nitrogen is used as a reactive gas. Nitrogen is used in the case of using the oxide as a target material.

In the embodiment, the film forming process is executed in such a manner that the more the position is away from the surface of the inorganic resist layer 2, that is, the more the position is close to the surface of the substrate 1, the more the sensitivity of the inorganic resist layer 2 increases. As a method of gradually increasing the sensitivity of the inorganic resist film, for example, there are the following two methods using the reactive sputtering . Vacuum degrees before and after the gas injection are set to predetermined values.

### [Method 1]

(1) In a sputtering apparatus, a film forming electric power is set to a predetermined value (for example, 150W) and a discharge is performed.
(2) During the film forming process of the inorganic resist film, the reactive gas ratio is changed as follows at the initial, middle, and end stages of the film forming process.
   (a) Initial stage of the film forming process:
      1st layer, 20nm thickness, reactive gas ratio = 9%
   (b) Middle stage of the film forming process:
      2nd layer, 30nm thickness, reactive gas ratio = 8%
   (c) End stage of the film forming process:
      3rd layer, 20nm thickness, reactive gas ratio = 7%

For example, in the stage (a), the sputtering is executed for 2 minutes and the resist film having the thickness of 20 nm is formed. The reactive gas ratio is a ratio of the reactive gas to the sum of the discharge gas and the reactive gas and is expressed by O₂/(Ar + O₂) in the case of using, for example, argon and oxygen.

### [Method 2]

(1) In the sputtering apparatus, the reactive gas ratio is set to a predetermined value (for example, 8%) and the discharge is performed.
   Or, the discharge can be also performed by using the target material of the same oxygen content without injecting the reactive gas.
(2) During the film forming process of the inorganic resist film, the film forming electric power is changed.
   (a) Initial stage of the film forming process:
      1st layer, 20nm thickness, film forming electric power = 100W
   (b) Middle stage of the film forming process:
      2nd layer, 30nm thickness, film forming electric power = 150W
   (c) End stage of the film forming process:
      3rd layer, 20nm thickness, film forming electric power = 200W

Although the film forming process is executed under the above three film forming conditions in the examples of the methods 1 and 2 mentioned above, those conditions can be sequentially switched during the continuous film forming process or when the film forming conditions are switched, it is also possible to temporarily stop the film forming process and execute the intermittent film forming process.

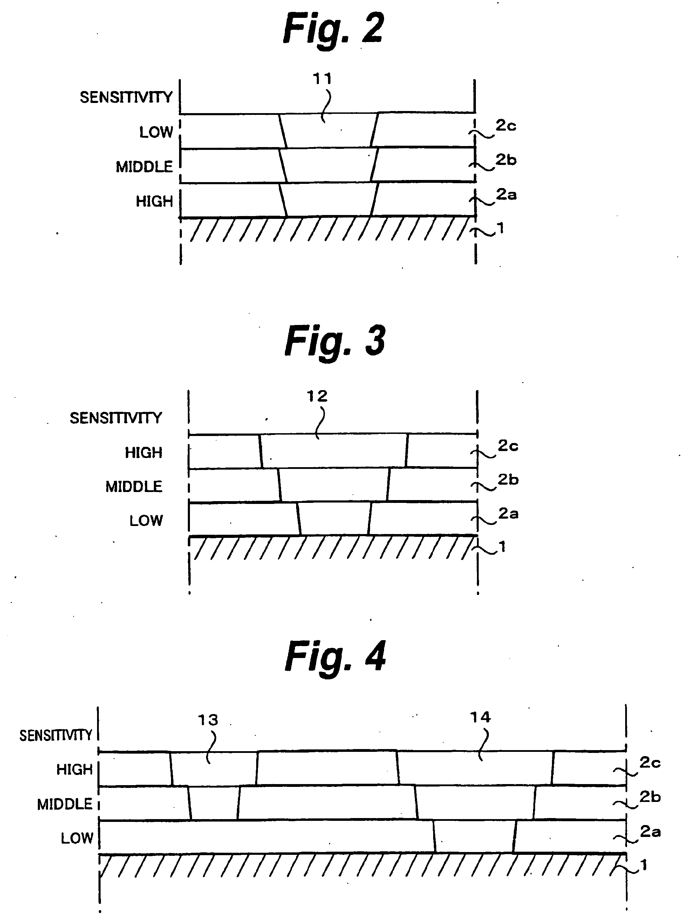

According to such control of the sputtering, at the initial stage of the film forming process, an oxygen concentration of the film is large and the sensitivity is high. On the other hand, at the end stage of the film forming process, the oxygen concentration is small and the sensitivity is low. Therefore, as shown in Fig. 2, the inorganic resist layer in which the sensitivity of a first layer 2a on the surface of the substrate 1 is high, that of a second layer 2b is middle, and that of a third layer 2c is low is formed.

Since the inorganic resist film in which the sensitivity is high in a portion near the bottom surfaces of the fine concave/convex patterns such as pits and grooves is provided according to the first embodiment, the flat bottom surfaces in which even if the laser or the like is irradiated, the development shortage phenomenon is difficult to occur near the bottom surfaces are obtained.

By raising the sensitivity of the first layer at the position far from the surface of the inorganic resist layer, the diffusion due to the thermal recording can be avoided. As shown in Fig. 2, since a concave portion 11 corresponding to the pit of the small opening portion can be formed on the disc master disc after the exposure and development, the optical disc of higher density can be formed. Even in the case of forming the groove deeper than the pit in the recordable optical disc, the groove in which the inclination of the inner wall surface is large can be formed without widening the opening portion.

The individual conditions and the number of condition changing times in each of the methods 1 and 2 can be arbitrarily selected so as to obtain the desired shapes and inclination angles of the fine concave/convex patterns such as pits and grooves and are not limited to those shown in the embodiment. Further, although the film forming process has been executed by fixing one of the film forming electric power and the reactive gas ratio and changing the other one in the methods 1 and 2, it is also possible to change both of the film forming electric power and the reactive gas ratio and preferably change the oxygen concentration of the resist film.

A manufacturing method of a master disc for an optical disc according to the second embodiment of the invention will now be described. According to the second embodiment, the film forming step and the laser irradiating (exposing) step in the first embodiment mentioned above are changed. Only the portions different from the processing steps in the first embodiment will be described here.

In the second embodiment, on the contrary to the first embodiment, the film forming process is executed in such a manner that as the position approaches the surface of the substrate 1 from the surface of the inorganic resist layer 2, the sensitivity of the inorganic resist layer 2 is decreased. As a method of changing the sensitivity of the inorganic resist layer 2 in the thickness direction as mentioned above, for example, there are the following two methods. A target material and a reactive gas upon sputtering similar to those in the first embodiment are used.

### [Method 3]

(1) In the sputtering apparatus, the film forming electric power is set to a predetermined value (for example, 150W) and the discharge is performed.
(2) During the film forming process of the inorganic resist film, the reactive gas ratio is changed as follows at the initial, middle, and end stages of the film forming process. The oxygen content is adjusted by changing the reactive gas ratio in a manner similar to the foregoing method 1.
   (a) Initial stage of the film forming process:
      1st layer, 20nm thickness, reactive gas ratio = 7%
   (b) Middle stage of the film forming process:
      2nd layer, 30nm thickness, reactive gas ratio = 8%
   (c) End stage of the film forming process:
      3rd layer, 20nm thickness, reactive gas ratio = 9%

For example, in the stage (a), the sputtering is executed for 2 minutes and the resist film having the thickness of 20 nm is formed. The reactive gas ratio is the ratio of the reactive gas to the sum of the discharge gas and the reactive gas and is expressed by O₂/(Ar + O₂) in the case of using, for example, argon and oxygen.

### [Method 4]

(1) In the sputtering apparatus, the reactive gas ratio is set to a predetermined value (for example, 8%) and the discharge is performed.
   Or, the discharge can be also performed by using the target material of the same oxygen content without injecting the reactive gas.
(2) During the film forming process of the inorganic resist film, the film forming electric power is changed.
   (a) Initial stage of the film forming process:
      1st layer, 20nm thickness, film forming electric power = 200W
   (b) Middle stage of the film forming process:
      2nd layer, 30nm thickness, film forming electric power = 150W
   (c) End stage of the film forming process:
      3rd layer, 20nm thickness, film forming electric power = 100W

Although the film forming process is executed under the three film forming conditions in the examples of the methods 3 and 4 mentioned above, those conditions can be sequentially switched during the continuous film forming process, or when the film forming conditions are switched, it is also possible to temporarily stop the film forming process and execute the intermittent film forming process.

According to such control of the sputtering, at the initial stage of the film forming process, an oxygen concentration of the film is small and the sensitivity is low. On the other hand, at the end stage of the film forming process, the oxygen concentration is large and the sensitivity is high. Therefore, as shown in Fig. 3, the inorganic resist layer in which the sensitivity of the first layer 2a on the surface of the substrate 1 is low, that of the second layer 2b is middle, and that of the third layer 2c is high is formed.

Since the sensitivity of the surface of the resist layer has been set to be high in the second embodiment, when the depth of pit is shallow, for example, 30nm or less, the inner wall surfaces of a concave portion 12 corresponding to the pit have a gentle inclination as shown in Fig. 3, transfer performance upon molding can be improved, and a cycle time can be shortened.

The individual conditions and the number of condition changing times in each of the methods 3 and 4 can be arbitrarily selected so as to obtain the desired shapes and inclination angles of the fine concave/convex patterns such as pits and grooves and are not limited to those shown in the embodiment. Further, although the film forming process has been executed by fixing one of the film forming electric power and the reactive gas ratio and changing the other one in the methods 3 and 4, it is also possible to change both of the film forming electric power and the reactive gas ratio and preferably change the oxygen concentration of the resist film.

By using the construction in which the sensitivity of the first layer on the substrate 1 is low, that of the second layer is middle, and that of the third layer is high as shown in the second embodiment and by switching the exposing power upon exposure shown in Fig. 1B, the pits and/or grooves of different depths can be formed.

For example, as shown in Fig. 4, in the case where a concave portion 13 corresponding to the pit for the ROM and a concave portion 14 corresponding to the groove for additional recording are formed on the same disc, an exposing power of, for example, a blue laser diode upon exposure is switched. With respect to the concave portion 13 corresponding to the pit for the ROM, the laser beam is irradiated by using the exposing power of about 10 mW. With respect to the concave portion 14 corresponding to the groove for the additional recording, the laser beam is irradiated by using the exposing power of about 15 mW. Thus, the hybrid optical disc having the pits for the ROM and the grooves for the additional recording which have the different depths can be manufactured.

As an example, the concave portion 13 corresponding to the ROM pit has a depth which reaches the second layer 2b formed at the middle stage of the film forming process. For example, the exposing portions of the second layer 2b and the third layer 2c are removed at the depth of about 125nm from the surface of the inorganic resist layer. The concave portion 14 corresponding to the groove for the additional recording has a depth which reaches the first layer 2a formed at the initial stage of the film forming process. That is, the exposing portions of the first layer 2a to the third layer 2c are removed at the depth of about 180nm from the surface of the inorganic resist layer. However, in this case, film forming times of the first layer, second layer, and third layer in [method 3] are set to 5 minutes and 30 seconds , 6 minutes , and 6 minutes and 30 seconds in [method 3], respectively.

Although two kinds of concave portions of the different depths have been formed to manufacture the hybrid optical disc in the second embodiment, the concave portions of various depths can be arranged on the same surface of the optical disc by the film forming process by the sputtering and the control of the exposing power in the exposing step as mentioned above.

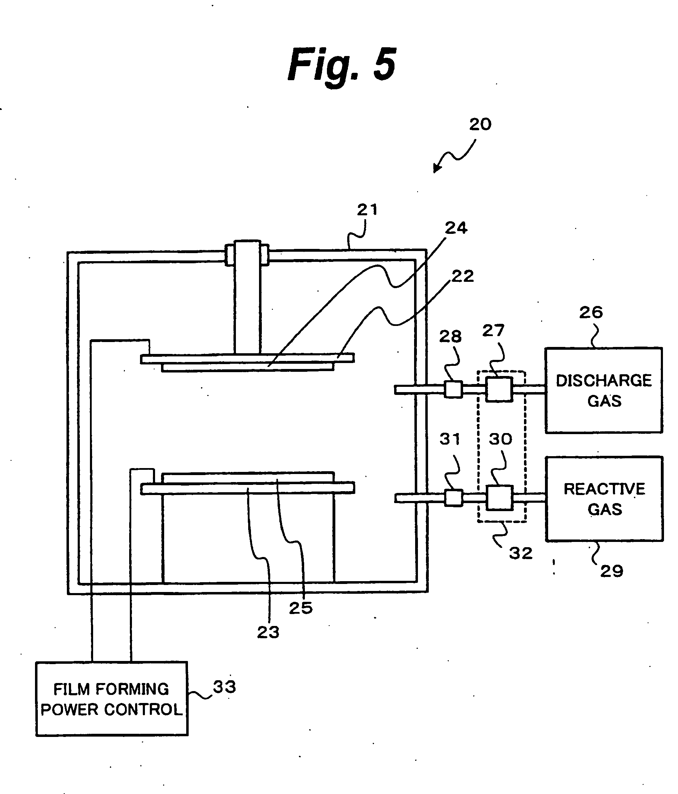

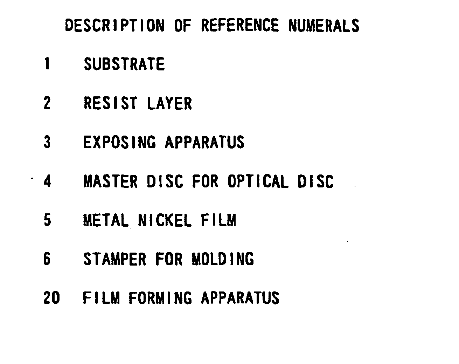

A film forming apparatus (sputtering apparatus) 20 which can embody the film forming method of the invention will now be described with reference to Fig. 5. In the film forming apparatus 20 , a cathode 22 and an anode 23 are provided in a vacuum film forming chamber 21, a target material 24 (a single element or alloy of a transition metal, or an oxide of them here) is attached to the cathode 22, and a substrate 25 is attached to the anode 23.

A discharge gas (for example, Ar gas) is enclosed in a gas cylinder 26 and supplied into the film forming chamber 21 through a stop valve 28 under the control of a mass flow controller 27. The mass flow controller 27 controls so as to feed a predetermined quantity of discharge gas into the film forming chamber 21 at predetermined timing during the film forming process.

In the case of executing the reactive sputtering, a reactive gas (for example, oxygen or nitrogen) is supplied from a gas cylinder 29 into the film forming chamber 21 through a mass flow controller 30 and a stop valve 31. The mass flow controller 30 controls so as to feed a predetermined quantity of reactive gas into the film forming chamber 21 at predetermined timing during the film forming process.

At a point of time when the discharge gas and the reactive gas have been introduced into the film forming chamber 21, by applying a predetermined voltage between the cathode 22 and the anode 23, a glow discharge is executed. A plasma generated by the glow discharge is used as an energy source and a film forming substance sputtered from the target material 24 is deposited onto the substrate 25, thereby forming a thin film. Such control of the film forming electric power is made by a film forming electric power control 33.

The film forming apparatus 20 is classified into a DC (Direct Current) type power source and an RF (Radio Frequency) type power source in dependence on whether a DC power source is used as a power source or an RF power source is used.

The film forming apparatus 20 makes the change control of the reactive gas ratio as mentioned above by a reactive gas ratio control 32 including the mass flow controllers 27 and 30 and makes the change control of the film forming electric power by the film forming electric power control 33. The reactive gas ratio control 32 and the film forming electric power control 33 are controlled by, for example, a microcomputer and control contents are instructed through programs or the like loaded in a memory.

According to the invention, it is possible to provide the manufacturing method of the master disc for the optical disc whereby in the case of forming the fine concave/convex patterns such as pits, grooves, and the like by phase-changing the inorganic resist, the sensitivity of the inorganic resist film is changed so that the bottom surfaces of the pits and grooves are stably formed in a flat shape and to provide the master disc for the optical disc manufactured by such a method.

According to the invention, it is possible to provide the manufacturing method of the master disc for the optical disc whereby the shapes and the inclination angles of the fine concave/convex portions such as pits, grooves, and the like are finely adjusted by changing the sensitivity of the inorganic resist film or the sensitivity of the inorganic resist film is changed so that the concave portions of the different depths can be formed in the same plane and to provide the master disc for the optical disc manufactured by such a method.

## Claims

1. A manufacturing method of a master disc for an optical disc (4), comprising:
a film forming step of forming an inorganic resist layer (2) made of an incomplete oxide of a transition metal as a film onto a substrate (1); and
a step of forming resist patterns including concave/convex shapes by exposing and developing said inorganic resist layer (2),
**characterized in that** in said film forming step, the oxygen concentration of said inorganic resist layer (2) is made different in its thickness direction.

2. A manufacturing method of the master disc for the optical disc (4) according to claim 1, wherein said oxygen concentration is decreased toward the surface of said substrate (1) from the surface of said inorganic resist layer (2).

3. A manufacturing method of the master disc for the optical disc (4) according to claim 1, wherein said oxygen concentration is increased toward the surface of said substrate (1) from the surface of said inorganic resist layer (2).

4. A manufacturing method of the master disc for the optical disc (4) according to claim 1, wherein
a single element or alloy of the transition metal, or an oxide of them is used as a target material, said inorganic resist layer (2) is formed as a film onto the substrate (1) by a sputtering method using oxygen or nitrogen as a reactive gas, and
the oxygen concentration of said inorganic resist layer (2) is made different in the thickness direction by changing at least either a film forming power or a reactive gas ratio.

5. A manufacturing method of the master disc for the optical disc (4) according to claim 4, wherein one of tungsten, molybdenum, tungsten molybdenum, and their oxide is used as said target material.

6. A manufacturing method of the master disc for the optical disc (4) according to claim 1, wherein the concave/convex shapes of different depths are formed by changing an exposing power to said inorganic resist layer (2).

7. A master disc for an optical disc (4) which is used when the optical disc having concave/convex shapes is manufactured, **characterized in that**
a substrate (1) is coated with an inorganic resist layer (2) in which oxygen concentration is made different in its thickness direction and which is made of an incomplete oxide of a transition metal, and the concave/convex shapes are formed in said inorganic resist layer (2).

8. A master disc for the optical disc (4) according to claim 7, wherein said oxygen concentration is decreased toward the surface of said substrate (1) from the surface of said inorganic resist layer (2) .

9. A master disc for the optical disc (4) according to claim 7, wherein said oxygen concentration is increased toward the surface of said substrate (1) from the surface of said inorganic resist layer (2).

10. A master disc for the optical disc (4) according to claim 7, wherein the concave/convex shapes of different depths are formed in said inorganic resist layer (2).

## Patentansprüche

1. Verfahren zum Herstellen einer Masterplatte für eine optische Platte (4), umfassend:
einen Filmausbildungsschritt zum Ausbilden einer anorganischen Lackschicht (2), die aus einem unvollständigen Oxid eines Übergangsmetalls besteht, als Film auf einem Substrat (1); und
einen Schritt zum Ausbilden von Lackmustern einschließlich konkaven/konvexen Formen durch Belichten und Entwickeln der anorganischen Lackschicht (2),
**dadurch gekennzeichnet, dass** die Sauerstoffkonzentration der anorganischen Lackschicht (2) in dem Filmausbildungsschritt in der Dickenrichtung unterschiedlich gestaltet wird.

2. Herstellungsverfahren der Masterplatte für die optische Platte (4) nach Anspruch 1, wobei die Sauerstoffkonzentration von der Oberfläche der anorganischen Lackschicht (2) in Richtung der Oberfläche des Substrats (1) reduziert wird.

3. Herstellungsverfahren der Masterplatte für die optische Platte (4) nach Anspruch 1, wobei die Sauerstoffkonzentration von der Oberfläche der anorganischen Lackschicht (2) in Richtung der Oberfläche des Substrats (1) erhöht wird.

4. Herstellungsverfahren der Masterplatte für die optische Platte (4) nach Anspruch 1, wobei
ein Einzelelement oder eine Legierung des Übergangsmetalls, oder ein Oxid hiervon als Targetmaterial verwendet wird, die anorganische Lackschicht (2) mit einem Sputterverfahren unter Verwendung von Sauerstoff oder Stickstoff als reaktivem Gas als Film auf dem Substrat (1) ausgebildet wird, und
die Sauerstoffkonzentration der anorganischen Lackschicht (2) in der Dickenrichtung unterschiedlich gestaltet wird durch Ändern von wenigstens entweder einer Leistung zum Ausbilden des Films oder eines reaktiven Gasverhältnisses.

5. Herstellungsverfahren der Masterplatte für die optische Platte (4) nach Anspruch 4, wobei eines der Elemente Wolfram, Molybdän, Wolfram-Molybdän und deren Oxid als Targetmaterial verwendet wird.

6. Herstellungsverfahren der Masterplatte für die optische Platte (4) nach Anspruch 1, wobei die konkaven/konvexen Formen unterschiedlicher Tiefe durch Ändern einer Belichtungsleistung der anorganischen Lackschicht (2) ausgebildet werden.

7. Masterplatte für eine optische Platte (4), die bei der Herstellung der optischen Platte mit konkaven/konvexen Formen verwendet wird, **dadurch gekennzeichnet, dass**
ein Substrat (1) mit einer anorganischen Lackschicht (2) bedeckt wird, in der die Sauerstoffkonzentration entlang der Dickenrichtung unterschiedlich gestaltet ist und die aus einem unvollständigen Oxid eines Übergangsmetalls besteht, wobei die konkaven/konvexen Formen in der anorganischen Lackschicht (2) ausgebildet sind.

8. Masterplatte für die optische Platte (4) nach Anspruch 7, wobei die Sauerstoffkonzentration von der Oberfläche der anorganischen Lackschicht (2) zur Oberfläche des Substrats (1) abnimmt.

9. Masterplatte für die optische Platte (4) nach Anspruch 7, wobei die Sauerstoffkonzentration von der Oberfläche der anorganischen Lackschicht (2) zur Oberfläche des Substrats (1) zunimmt.

10. Masterplatte für die optische Platte (4) nach Anspruch 7, wobei die konkaven/konvexen Formen unterschiedlicher Tiefe in der anorganischen Lackschicht (2) ausgebildet sind.

## Revendications

1. Procédé de fabrication d'un disque de verre pour un disque optique (4), comprenant :
une étape de formation de film consistant à former une couche de réserve inorganique (2) constituée d'un oxyde incomplet d'un métal de transition en tant que film sur un substrat (1) ; et
une étape de formation de motifs de réserve incluant des formes concaves/convexes par exposition et développement de la couche de réserve inorganique (2),
**caractérisé en ce que** dans ladite étape de formation de film, la concentration en oxygène de ladite couche de réserve inorganique (2) est rendue différente dans la direction de sa largeur.

2. Procédé de fabrication du disque de verre pour le disque optique (4) selon la revendication 1, dans lequel ladite concentration en oxygène est diminuée vers la surface dudit substrat (1) à partir de la surface de ladite couche de réserve inorganique (2).

3. Procédé de fabrication du disque de verre pour le disque optique (4) selon la revendication 1, dans lequel ladite concentration en oxygène est augmentée vers la surface dudit substrat (1) à partir de la surface de ladite couche de réserve inorganique (2).

4. Procédé de fabrication du disque de verre pour le disque optique (4) selon la revendication 1, dans lequel
un élément unique ou alliage du métal de transition, ou un oxyde de ces derniers est utilisé comme matériau cible, ladite couche de réserve inorganique (2) est formée comme un film sur le substrat (1) par un procédé de pulvérisation cathodique utilisant de l'oxygène ou de l'azote comme gaz réactif, et
la concentration en oxygène de ladite couche de réserve inorganique (2) est rendue différente dans la direction de l'épaisseur en changeant au moins l'un ou l'autre parmi une puissance de formation de film ou un rapport de gaz réactif.

5. Procédé de fabrication du disque de verre pour le disque optique (4) selon la revendication 4, dans lequel un élément parmi le tungstène, le molybdène, le tungstène-molybdène, et leur oxyde est utilisé comme ledit matériau cible.

6. Procédé de fabrication du disque de verre pour le disque optique (4) selon la revendication 1, dans lequel les formes concaves/convexes de différentes profondeurs sont formées en changeant une puissance d'exposition fournie à ladite couche de réserve inorganique (2).

7. Disque de verre pour un disque optique (4) qui est utilisé lorsque le disque optique comportant des formes concaves/convexes est fabriqué, **caractérisé en ce que**
un substrat (1) est revêtu avec une couche de réserve inorganique (2) dans laquelle la concentration en oxygène est rendue différente dans la direction de son épaisseur et qui est constituée d'un oxyde incomplet d'un métal de transition, et les formes concaves/convexes sont formées dans ladite couche de réserve inorganique (2).

8. Disque de verre pour le disque optique (4) selon la revendication 7, dans lequel ladite concentration en oxygène est diminuée vers la surface dudit substrat (1) à partir de la surface de ladite couche de réserve inorganique (2).

9. Disque de verre pour le disque optique (4) selon la revendication 7, dans lequel ladite concentration en oxygène est augmentée vers la surface dudit substrat (1) à partir de la surface de ladite couche de réserve inorganique (2).

10. Disque de verre pour le disque optique (4) selon la revendication 7, dans lequel les formes concaves/convexes de différentes profondeurs sont formées dans ladite couche de réserve inorganique (2).
